Europäisches Patentamt

European Patent Office

Office européen des brevets

(11) Publication number : **0 655 698 A1**

# EUROPEAN PATENT APPLICATION

(21) Application number : 94308761.9

(22) Date of filing : 28.11.94

(51) Int. Cl.⁶ : **G06F 19/00**, G05D 1/06, G01C 21/00

(30) Priority : 30.11.93 US 159651
18.01.94 US 182891
18.01.94 US 182894

(43) Date of publication of application :
**31.05.95 Bulletin 95/22**

(84) Designated Contracting States :
**DE FR GB**

(71) Applicant : **HONEYWELL INC.**
**Honeywell Plaza**
**Minneapolis Minnesota 55408 (US)**

(72) Inventor : **Price, David N.**
**7667 North Wickham Road, No. 1204**
**Melbourne, Florida 32940 (US)**

(74) Representative : **Fox-Male, Nicholas Vincent**
**Humbert**
**Honeywell Control Systems Limited,**
**Honeywell House,**
**Arlington Business Park**
**Bracknell, Berkshire RG12 1EB (GB)**

(54) **Low level flight flyability transformation of digital terrain elevation data.**

(57)    A flyability index represents a quantified low level flight risk associated with each data post in a digital terrain elevation data (DTED) aircraft flight system. Data posts immediately surrounded by terrain slope approximately equal to or less then the climb or dive angle capability of the aircraft have a zero flyability index, and thereby indicate no risk to a low level, set clearance terrain following flight thereover. As the surrounding terrain rises or descends at a greater rate, i.e., greater than aircraft capability, the flyability index values increase to show increasing risk in low level, e.g., terrain following, flight thereover. The illustrated method of transformation provides a single flyability index value for association with each data post of interest, and can be thereby easily integrated into an existing DTED database system.

FIG. 1

## BACKGROUND OF THE INVENTION

The present invention relates generally to use of digital terrain elevation data (DTED), and particularly to a method of transforming conventional digital terrain elevation data to derive a flyability index for each data post of the digital terrain elevation data.

Digital terrain elevation data represents surface altitude at discrete "data posts." Each data post has a surface location or address, e.g., latitude and longitude, and an associated altitude, e.g., vertical offset relative to sea level. Thus, a simple form of a DTED database would deliver a scaler altitude in response to longitude and latitude input. More complicated DTED databases have been developed for certain applications. For example, U.S. Patent No. 4,899,292 issued February 6, 1990 to J. F. Dawson and E. W. Ronish shows a tessellation method for creating a spherical database by warping a digital map, including digital terrain elevation data, by longitude and latitude parameters.

DTED database systems are used in flight mission computer systems and flight planning strategy in military applications to aid in, for example, covert and evasive flight operations. As used in mission computer systems, a DTED database can aid a pilot in recommending time-critical maneuvers.

A DTED database may be referenced to aid in the selection of flight routes, but must be accurate in the results obtained. Referencing a DTED database to select a given route must provide a flight path meeting a variety of potentially critical requirements ranging from threat visibility concerns to aircraft flight capability concerns with respect to the terrain slope, especially in the context of low level terrain following flight. As may be appreciated, the accuracy in characterizing the flyability of a given flight route can be vitally critical. If a route is selected for low level terrain following flight, but the terrain contour makes impossible such flight, the mission could fail. Thus, improvements in methods of characterizing terrain based upon DTED analysis are not simply improvements in computational elegance, but can be life-saving and critical to mission success.

Terrain following flight becomes particularly critical when executed at low above ground elevations, especially at fixed above ground elevations. If the terrain following flight is to be executed with little or no active sensor data, it is necessary to view a DTED database in a manner revealing appropriate, i.e., possible or relatively risk-free, flight routes for low level terrain following flight.

A DTED database may be referenced to determine local minimums of terrain elevation, with the assumption that local minimums of terrain elevation correlate closely with gently-sloping terrain. Unfortunately, this assumption is not true in every case. The correlation between absolute terrain elevation and the readiness which an aircraft can perform terrain following flight is weak. Accordingly, identifying local minimums of terrain elevation could indicate a region as being "flyable" for low level terrain following flight when in fact such a region is either difficult, dangerous, or impossible to perform such flight.

In flight path selection procedures, especially in pre-flight route selection, many factors are considered in choosing appropriate flight paths. Typically, hostile forces must be considered, including known threat installations and the potential for previously unknown threat installations detected while in flight. Thus, flight planning sometimes includes selection of flight paths having the characteristic of restricted visibility with respect to specific threat installations. Such restricted visibility is usually provided by terrain masking, i.e., intervening terrain features hiding an aircraft from detection by a threat installation. Thus, visibility is one factor to be weighed in flight path selection. Heretofore, visibility has been quantified by intervisibility calculations identifying terrain not visible with respect to known threat installations. This quantified characteristic of a potential flight path is incorporated into a flight path selection process. Heretofore, the "flyability" of a given low level terrain following flight path has been difficult or impossible to quantify sufficiently for integration into flight path selection procedures, i.e., for comparison to other flight path selection criteria. The predominant factor in flight path selection has been visibility or terrain masking criteria. The terrain following flight devices of the aircraft and the capability of the pilot are then relied upon during flight to manage whatever terrain conditions may lie along a selected flight path.

Route planning and mission replans using only hideability or terrain masking analysis, however, lack sufficient constraining factors to discourage low level terrain following flight over potentially dangerous terrain, i.e., rugged terrain with high slope. Flight paths selected primarily, or only, for the characteristic of terrain masking with respect certain observation points, i.e., threat installations, can present hazard to the low level terrain following aircraft. Accordingly, in addition to other criteria for route selection, low level flight flyability risk should be quantified for consideration in flight planning.

It would be desirable, therefore, to develop a quantified cost or risk index to represent the difficulty of low level flight over a particular data post in a DTED database. Such a risk index can be considered in conjunction with other route selection criteria to account for flyability hazards to low level terrain following flight missions.

## SUMMARY OF THE INVENTION

The present invention provides apparatus for evaluating flyability for a given aircraft having a given flight capability above a given ground terrain represented by terrain data including altitude posts, the apparatus characterised by means to select a given post; means to calculate a terrain slope summation as the sum of altitude differences between the selected post and a set of surrounding posts; means to calculate a slope threshold as a function of the given aircraft flight capability; means to compare said terrain slope summation and said slope threshold; and means to evaluate flyability above said given post as a function of the output of said means to compare

The present invention also provides a method of evaluating flyability for a given aircraft having a given flight capability above a given ground terrain represented by terrain data including altitude posts, the method characterised by selecting a given post; calculating a terrain slope summation as the sum of altitude differences between the selected post and a set of surrounding posts; calculating a slope threshold as a function of the given aircraft flight capability; comparing said terrain slope summation and said slope threshold; and evaluating flyability above said given post as a function of said comparing step.

The present invention contemplates a quantified flyability index which may be employed in flight path selection procedures. Because the flyability index is quantified, such an index may be easily integrated into flight path selection procedures which may weigh and compare various selection criteria in identifying an optimal flight path. Under the present invention, the terrain slope surrounding a given DTED data post is characterized by a quantified value. This quantified value is then compared to the climb or dive capability of a specific aircraft proposed under a flight plan. If the climb or dive capability of the aircraft exceeds the slope of the terrain as indicated by the quantified slope indicator, then the terrain at the data post is considered "flyable." If the terrain slope indicator portrays terrain slope exceeding the climb or dive capabilities of the aircraft, a quantified risk factor is indicated in the resulting flyability index.

In accordance with a preferred embodiment of the present invention, the low level flyability risk at each point of interest in a DTED database is computed by first summing the magnitude of the elevation change from the point of interest to each of the surrounding, e.g., 8, DTED data posts. This sum is then mapped to a flyability index by reference to the climb or dive angle capability of the aircraft under consideration. A flyability index of zero represents a "no risk" terrain slope having lesser magnitude than the climb or dive capability of the aircraft under consideration. A non-zero flyability index represents a "risk cost" terrain slope having magnitude greater than the climb or dive capability of the aircraft under consideration. The flyability index is a positive value having a magnitude corresponding to the magnitude of low level flight risk over the associated data post. In other words, large flyability index values represent a quantified risk to low level flight.

The flyability index under the present invention is a direct indication of flyability throughout a DTED database, and is independent of flight path. The utility of this flyability index includes use to determine the readiness with which an aircraft can perform terrain following flight over some ground track of interest. In this manner, a relatively risk free low altitude ground track or ground region, i.e., a track or region which avoids areas over which terrain following flight is difficult or hazardous, may be identified. All areas having terrain slope within the climb or dive capability of the aircraft under consideration appear equally flyable for low level flight, and increasingly rugged terrain is revealed by increasingly larger flyability index values.

The subject matter of the present invention is particularly pointed out and distinctly claimed in the concluding portion of this specification. However, both the organization and method of operation of the invention, together with further advantages and objects thereof, may best be understood by reference to the following description taken with the accompanying drawings wherein like reference characters refer to like elements.

## BRIEF DESCRIPTION OF THE DRAWINGS

For a better understanding of the invention, and to show how the same may be carried into effect, reference will now be made, by way of example, to the accompanying drawings in which:

FIG. 1 illustrates a portion of DTED database including a data post of interest, for which a flyability index is to be computed, and 8 surrounding data posts.

FIG. 2 illustrates a contour map of elevation for a given region of DTED database.

FIG. 3 illustrates a flyability map in accordance with the present invention of the same region of a DTED database as shown in FIG. 2.

## DETAILED DESCRIPTION OF THE PREFERRED EMBODIMENT

The present invention provides a method of flyability analysis which may be applied to a DTED database. The method of analysis provides a scaler value for association with each data post of a DTED database and a given aircraft climb or dive angle. Thus, the results of flyability analysis under the present invention can be incorporated into a DTED database by including additional depth in the DTED database for storage of a flyability index value or values in association with each data post in the DTED database. The following discussion will focus on the computation of a flyability index for a given data post in a DTED database. It will be understood, however, that a plurality of data posts in a given region of a DTED database can receive a flyability index value to produce, for example, a flyability display for a pilot executing low level terrain following flight maneuvers, or to provide a basis for low level flight path selection incorporating flyability as a preflight selection criteria.

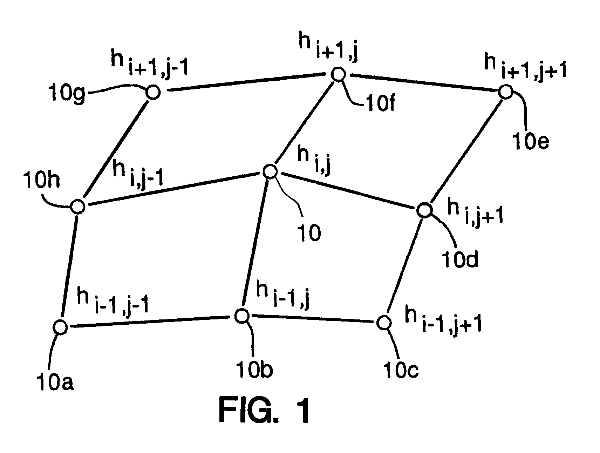

FIG. 1 illustrates a data post 10 of a DTED database for which a flyability index is to be computed. The 8 data posts 10a-10h surrounding data post 10 define a flyability index for data post 10. The data post 10 at address (ij) stores altitude data $h_{ij}$ and the surrounding data posts 10a-10h store altitude data shown addressed relative to the address of data post 10. For example, $h_{ij+i}$ is altitude data for the post 10d at address (i,j+1). The first step in computing a flyability index for data post 10 is summation of altitude differences between the data post 10 and each of the data posts 10a-10h as follows:

$$I_{i,j} = \Sigma \left| h_{i,j} - h_{i + m, j + n} \right|$$

m=-1 to 1
n=-1 to 1
$I_{i,j}$=flyability of DTED post i,j
$h_{i,j}$=altitude of DTED post i,j

The above summation $I_{ij}$ represents generally terrain slope in the vicinity of the data post at address (i,j) and is independent of any risk considerations associated with specific aircraft capability. Thus, a DTED database can be preprocessed to compute the terrain slope summation $I_{i,j}$ for a set of DTED posts 10. Separate flyability index values for different flight capability parameters, i.e., for different aircraft may then be associated with each post 10 as a function of the terrain slope summation I.

The next step in computing a flyability index for the data post 10 requires comparison of the terrain slope summation $I_{i,j}$ with the climb or dive capability of a particular aircraft under consideration. All values of the summation $I_{i,j}$ representing terrain slope below the maximum desired climb or dive angle of the aircraft under consideration are mapped to a flyability index of zero to indicate a completely flyable or risk-free point. Values of summation $I_{i,j}$ representing terrain slope greater than the maximum climb or dive angle of the aircraft under consideration are mapped to positive values having magnitude corresponding to low level flight risk. First, a threshold value for the summation $I_{i,j}$ is computed as follows:

$$I_{thresh} = 6 * (delta\ x) * \tan \theta$$

Where delta x represents data post spacing, e.g., equals the DTED data post horizonal spacing, and where Q represents aircraft flight capability, e.g., equals the maximum climb or dive angle of the aircraft under consideration. The factor of 6 used in the above equation corresponds to an assumption that the terrain slopes in only one direction. This results from the observation that terrain generally does not instantaneously change slope. The importance of the above calculation is a normalization of the resulting threshold value. A variety of factors, including potentially complex factors, can be incorporated into the computation of the above threshold. It would be difficult, however, to derive one threshold calculation absolutely correct for all cases. Thus, the above computation normalizes the resulting threshold and provides a consistent threshold value for all data posts analyzed. Because of this consistency, it is possible to compare or rank the resulting flyability index values and successfully compare flight hazard or risk cost for various potential flight paths under consideration. The calculated threshold value $I_{thresh}$, thereby provides a suitable reference for relative ranking of flyability index values obtained.

Thus, if the summation $I_{i,j}$ is equal to or less than the value $I_{thresh}$ then the flyability index for the data post 10 will equal zero. If the value of summation $I_{i,j}$ is greater than the value of $I_{thresh}$, than the flyability index is computed as ($I_{i,j} - I_{thresh}$). In this manner, increasing values of the flyability summation $I_{i,j}$ are mapped monotonically to increasing values of the flyability index. This flyability index can be taken as a risk cost index wherein the bigger the index value the greater the penalty incurred in overflying the associated DTED data post.

The method of flyability analysis of the present invention provides a direct indication of expected difficulty in maintaining a set clearance or flight elevation over any given DTED data post or data post region during terrain following flight. The analysis requires simple computation which may be executed in advance of a given mission and stored in association with the DTED database elevation data.

Thus, when generating low level terrain following flight plans there is provided a method of quantifying the risk or difficulty the aircraft may experience in attempting to maintain a low above ground altitude, i.e., maintaining a "set clearance." A planned flight path can avoid areas having a high flyability cost, i.e., a high flyability index, especially where a terrain following flight plan calls for a constant and low above ground elevation.

One example of flight planning improved by use of the present invention is the use of an automated search algorithm to find least cost flight paths. For example, a point of origin and point of destination are identified with respect to a given flight mission using a given aircraft. A search algorithm may be employed to build a tree structure representing potential low level flight paths between the point of origin and the point of destination while summing the flyability index values for data posts along each potential route selection. In this manner, each route may be associated with a flight hazard risk index whereby route selections may be compared based upon a quantified risk value. Thus, where prior route selection procedures have selected a route primarily for visibility characteristics, the present invention identifies any such selected low level routes as being relatively risk free, potentially dangerous, or impossible based upon the risk hazards encountered therealong. As may be appreciated, identified risk hazard areas can be either avoided or possibly a relatively higher above ground elevation employed therethrough to minimize flyability risks.

In general, the method of the present invention tends to "prune out" flight routes which may have otherwise been selected but presented hazard to low level terrain following flight missions. Accordingly, the method of the present invention offers advantage in improving the likelihood of mission success.

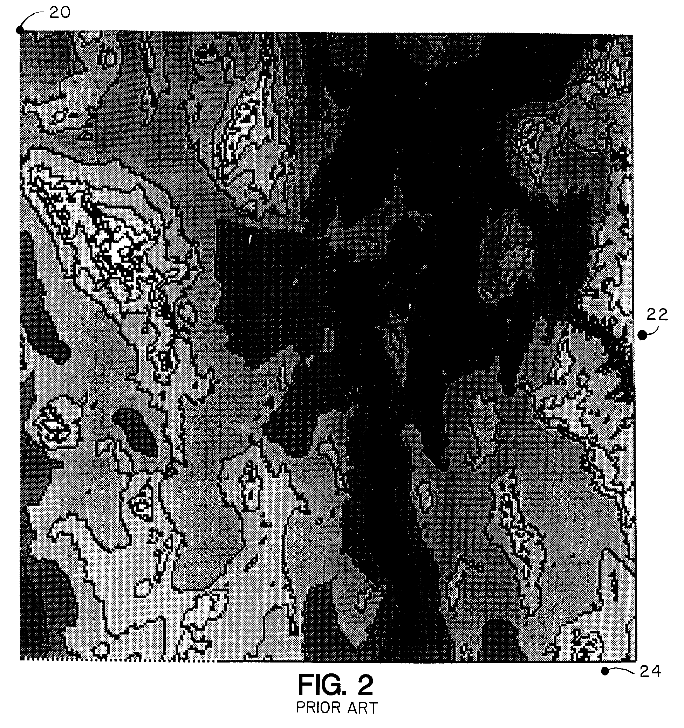

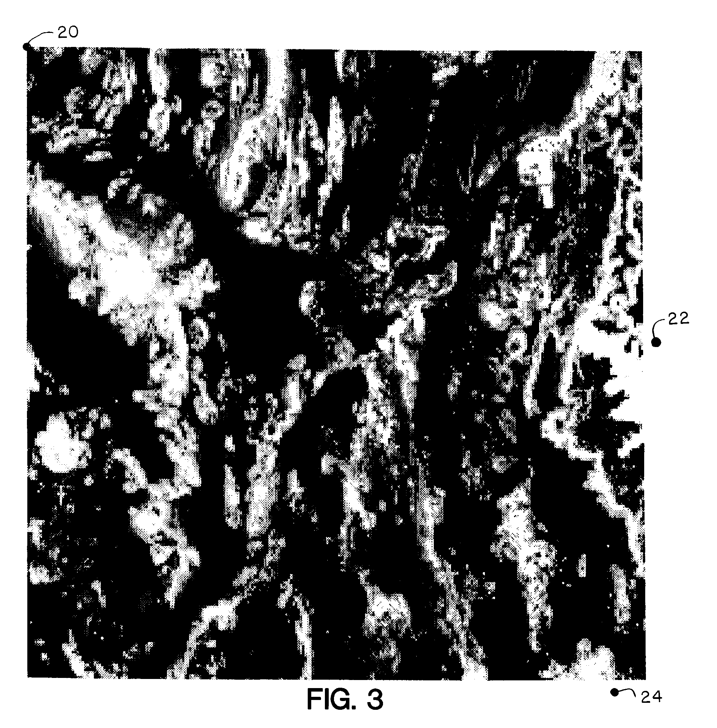

FIGS. 2 and 3 are computer generated output taken from a DTED database presented to illustrate the difference between flyability analysis under prior methods of mapping altitude data to color (FIG. 2) and analysis under the present invention (FIG. 3). FIGS. 2 and 3 depict the same region of a DTED data base, in this case a region centered generally on Las Vegas, Nevada. Reference points in the margins identify features of the illustration. Reference point 20 corresponds to an absolute position of N 36 degrees, 55 minutes and W 116 degrees 3 minutes. The square area depicted covers approximately 104 nautical miles in each dimension.

FIG. 2 is a contour map of elevation at 1000 foot contours with black representing low regions and white representing high regions. As previously discussed, such data has been used to infer flyability, but the correlation between absolute terrain elevation and flyability is weak. For example, reference points 22 and 24 indicate, i.e., at the intersection of a horizontal line through point 22 and a vertical line through point 24, generally the end of the Grand Canyon. If low regions, i.e., shaded more black in the depiction of FIG. 2, were selected based on the assumption that low regions are more flyable, the guidance provided by the illustration of FIG. 2 would be in error. This terrain feature is low terrain, but too rough to safely attempt low level terrain following flight.

FIG. 3 is a flyability map produced in accordance with the present invention. In particular, black areas correspond to a flyability index of zero, i.e., no flight risk for low level terrain following flight, and white regions depict the highest flight risk. In contrast to the guidance provided by FIG. 2, the depiction of the same terrain feature, again indicated by the points 22 and 24, shows a flight risk and could be avoided by use of the present invention. As may be appreciated, the illustration of FIG. 3 could be presented by electronic display to a pilot dynamically during flight or during flight planning. As discussed above, the data supporting the illustration of FIG. 3 could be evaluated according to automated flight path selection algorithms.

This invention has been described herein in considerable detail in order to comply with the Patent Statutes and to provide those skilled in the art with the information needed to apply the novel principles and to construct and use such specialized components as are required. However, it is to be understood that the invention is not restricted to the particular embodiment that has been described and illustrated, but can be carried out by specifically different equipment and devices, and that various modifications, both as to the equipment details and operating procedures, can be accomplished without departing from the scope of the invention itself.

**Claims**

1. Apparatus for evaluating flyability for a given aircraft having a given flight capability above a given ground terrain represented by terrain data including altitude posts, the apparatus characterised by:
   means to select a given post;
   means to calculate a terrain slope summation as the sum of altitude differences between the selected post and a set of surrounding posts;
   means to calculate a slope threshold as a function of the given aircraft flight capability;
   means to compare said terrain slope summation and said slope threshold; and
   means to evaluate flyability above said given post as a function of the output of said means to compare.

2. Apparatus according to Claim 1 characterised by means to evaluate flyability for low level terrain following flight of said given aircraft above the given ground terrain.

3. Apparatus according to Claim 1 or 2 characterised by means to calculate a slope threshold as a function also of a separation between the given post and at least one of said set of surrounding posts.

4. Apparatus according to any preceding Claim, characterised in that said given aircraft flight capability represents at least one of a maximum climb angle and a maximum dive angle for said aircraft.

5. Apparatus according to any preceding Claim characterised in that the means to evaluate comprises means to calculate a flyability index associated with said given post wherein said flyability index equals a given value when said terrain slope summation bears a first relationship to said slope threshold and a quantified value when said terrain slope summation bears a second relationship to said slope threshold, said quantified value being a function of the output of the means to compare.

6. Apparatus according to Claim 5 characterised in that said quantified value corresponds in magnitude to a difference between said terrain slope summation and said slope threshold.

7. Apparatus according to any preceding Claim characterised by means to further execute the flyability evaluation against a collection of selected posts corresponding to a given ground region to determine flyability over said given ground region.

8. A method of evaluating flyability for a given aircraft having a given flight capability above a given ground terrain represented by terrain data including altitude posts, the method characterised by:

selecting a given post;

calculating a terrain slope summation as the sum of altitude differences between the selected post and a set of surrounding posts;

calculating a slope threshold as a function of the given aircraft flight capability;

comparing said terrain slope summation and said slope threshold; and

evaluating flyability above said given post as a function of said comparing step.

9. A method according to Claim 8 characterised in that said method is executed to evaluate flyability for low level terrain following flight of said given aircraft above the given ground terrain.

10. A method according to Claim 8 or 9 characterised in that said step of calculating a slope threshold is a function also of a separation between the given post and at least one of said set of surrounding posts.

11. A method according to any of Claims 8 to 10 characterised in that said given aircraft flight capability represents at least one of a maximum climb angle and a maximum dive angle for said aircraft.

12. A method according to any of Claims 8 to 11 characterised in that said step of evaluating comprises calculating a flyability index associated with said given post wherein said flyability index equals a given value when said terrain slope summation bears a first relationship to said slope threshold and a quantified value when said terrain slope summation bears a second relationship to said slope threshold, said quantified value being a function of said comparing step.

13. A method according to any of Claims 8 to 12 characterised in that said quantified value corresponds in magnitude to a difference between said terrain slope summation and said slope threshold.

14. A method according to any of Claims 8 to 13 characterised in that said method is further executed against a collection of selected posts corresponding to a given ground region to determine flyability over said given ground region.

FIG. 1

FIG. 2
PRIOR ART

FIG. 3

European Patent
Office

**EUROPEAN SEARCH REPORT**

Application Number

EP 94 30 8761

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| A | EP-A-0 453 327 (SEXTANT AVIONIQUE SA) 23 October 1991 <br> * the whole document * | 1,8 | G06F19/00 <br> G05D1/06 <br> G01C21/00 |

TECHNICAL FIELDS
SEARCHED (Int.Cl.6)

G05D
G01C
F41G
G06F

The present search report has been drawn up for all claims

| Place of search | Date of completion of the search | Examiner |
|---|---|---|
| THE HAGUE | 22 February 1995 | Guingale, A |

EPO FORM 1503 03.82 (P04C01)